# EUROPEAN PATENT APPLICATION

(11) **EP 1 251 724 A2**
(43) Date of publication of application: **23.10.2002**
(21) Application number: 01119771.2
(22) Date of filing: 28.08.2001
(51) Int. Cl.: H05K 1/16

(54) **Electric circuit board including glass substrate and method and apparatus for trimming thereof**

(30) Priority: 18.04.2001 JP 2001119447
(71) Applicant: Hitachi, Ltd., Chiyoda-ku, Tokyo (JP)
(72) Inventor: Kojima, Yasuyuki, Hitachi, Ltd., Int. Prop. Gp., Chiyoda-ku, Tokyo 100-8220 (JP); Yukutake, Seigou, Hitachi, Ltd., Int. Prop. Gp., Chiyoda-ku, Tokyo 100-8220 (JP); Akiyama, Noboru, Hitachi, Ltd., Int. Prop. Gp., Chiyoda-ku, Tokyo 100-8220 (JP); Miwa, Takao, Hitachi, Ltd., Int. Prop. Gp., Chiyoda-ku, Tokyo 100-8220 (JP); Naito, Takashi, Hitachi, Ltd., Int. Prop. Gp., Chiyoda-ku, Tokyo 100-8220 (JP); Sato, Toshiya, Hitachi, Ltd., Int. Prop. Gp., Chiyoda-ku, Tokyo 100-8220 (JP)
(74) Representative: Beetz & Partner Patentanwälte

(57) **Abstract**

There is disclosed a method of narrowing a focus of a powerful electromagnetic wave (17) such as excimer laser toward a capacitor formed in a glass substrate (1), and adjusting and trimming a change amount of crystallized glass formed in this portion in a limited manner. A capacity value can be trimmed without influencing an outer configuration and other peripheral components, a circuit board whose property is unchanged and whose dispersion is little can be manufactured, and the capacity value can more precisely be adjust

## Description

### BACKGROUND OF THE INVENTION

### i) Field of the Invention

The present invention relates to an electric circuit board including a glass substrate, and a method and apparatus for trimming the electric circuit board, particularly to an electric circuit board including a glass substrate on which elements constituting an electric circuit are mounted, and a method and apparatus for adjusting properties of the electric circuit constituting elements mounted on the electric circuit board.

### ii) Description of The Related Art

As a method for trimming an electric circuit constituting element formed on an electric circuit board, a method of irradiating the element with an electromagnetic wave and thermally changing a crystalline state of a substrate composition is known as disclosed in Japanese Patent Application JP-A-10-55932.

### SUMMARY OF THE INVENTION

An object of the present invention is to provide an electric circuit constituting element in an electric circuit board including a glass substrate, which can locally be adjusted in an aiming manner without influencing a periphery of the element, a trimming method for adjusting electric properties, an electric circuit board whose electric properties are adjusted by the trimming method, and a trimming apparatus.

In the aforementioned prior art, a thermal trimming method by laser is used. As a result, a peripheral porcelain composition is heated from an electrode portion which largely and easily absorbs an electromagnetic wave as compared with the porcelain composition. Then, heat unnecessarily spreads, even an unnecessary portion is changed in properties, and the properties of other formed components are possibly changed. Therefore, a property adjustment operation includes a trial and error factor, and a turnaround time (TAT) does not increase. Besides this problem, since there is an influence of heat spread, another element cannot be disposed around, mounting density cannot be raised, size increases, and efficiency decreases, but cost increases. Moreover, an electrode influenced by heat strain is deformed, high-frequency transmission property changes, or the circuit board warps. There is a possibility that reliability of electrode connection changes.

Furthermore, a scanning circuit, DA conversion circuit, and the like are mounted on a liquid crystal panel, and an integration degree increases in future. It is then expected that wiring needs to be corrected in order to remedy a defect during trimming for properties adjustment or during manufacturing.

According to one aspect of the present invention, an inner portion of glass of a glass substrate is focused and irradiated with a laser beam as a powerful electromagnetic wave for a short time, and the inner portion of the glass substrate is distinguished from other portions and partially changed in state. Thereby, for example, a plurality of crystal grains or crystal rods are formed inside the glass substrate, and an electric capacity, that is, a capacitor is formed in the glass substrate. A capacity value of the capacitor can be adjusted by irradiation of the laser beam.

For laser, yttrium aluminum garnet (YAG) having a wavelength of about 1 µm is not used, and a strong-energy electromagnetic wave such as excimer laser having a wavelength of about 0.2 µm to 0.35 µm is used. For a glass material, glass which mainly contains Li₂O-SiO₂, absorbs ultraviolet light and is easily crystallized, that is, so-called crystallized glass is used as a raw material. A crystal of lithium silicate or α silicon is generated by local laser heating. Alternatively, an electric circuit constituting element disposed opposite to the glass substrate is focused and trimmed through the glass substrate.

Therefore, a portion other than an aimed fine portion is not influenced, and property dispersion or yield deterioration of a product does not occur.

According to the present invention, since the electric circuit constituting element of the circuit board can locally be trimmed by irradiation of the strong electromagnetic wave such as the laser beam, the element can be adjusted with little influence onto the peripheral component. Moreover, when crystallized glass is formed in the glass substrate by trimming, the electric capacity value can be trimmed without changing an outer configuration.

### BRIEF DESCRIPTION OF THE DRAWINGS

FIG. 1 shows a schematic sectional view of a circuit board and a schematic diagram of a trimming apparatus according to a first embodiment of the present invention.
FIG. 2 is a graph showing permittivity profile after trimming in the first embodiment.
FIG. 3 shows a schematic sectional view of the circuit board and a schematic diagram of the trimming apparatus according to a second embodiment of the present invention.
FIG. 4 shows a schematic sectional view of the electric circuit board whose capacity can easily be trimmed, and a schematic diagram of the trimming apparatus according to the first embodiment.
FIG. 5 shows a schematic perspective view of the electric circuit board whose capacity can easily be trimmed, and a schematic diagram of the trimming apparatus according to the second embodiment.
FIG. 6 shows a schematic perspective view of the electric circuit board whose capacity can easily be trimmed, and a schematic diagram of the trimming apparatus according to a third embodiment.
FIG. 7 shows a schematic perspective view of the electric circuit board whose capacity can easily be trimmed, and a schematic diagram of the trimming apparatus according to a fourth embodiment.
FIG. 8 is a schematic sectional view of a first example of a multilayered electric circuit board according to the present invention.
FIG. 9 is a schematic sectional view of a second example of the multilayered electric circuit board according to the present invention.
FIGS. 10A, 10B are flowcharts of a trimming adjustment process of the electric circuit board according to the embodiment of the present invention.
FIG. 11 is a schematic diagram of a manufacturing apparatus including an evaluation step and trimming step according to the embodiment of the present invention.
FIG. 12 is a schematic sectional view of a glass substrate on a circuit side of a liquid crystal panel during modifying of wiring according to the embodiment of the present invention.

### DETAILED DESCRIPTION OF THE EMBODIMENTS

Preferred embodiments of the present invention will be described hereinafter in detail with reference to the drawings. Additionally, in all explanatory views of the embodiments, components having the same function are denoted with the same reference numerals, and redundant description is omitted.

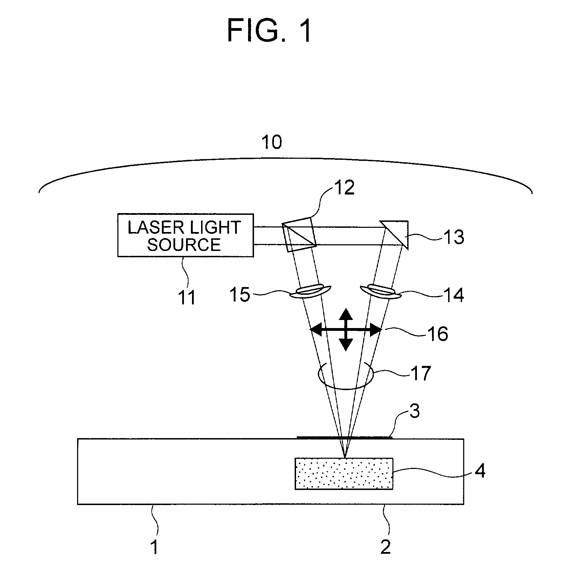

FIG. 1 shows a schematic sectional view of a circuit board and a schematic diagram of a trimming apparatus according to a first embodiment of the present invention. In FIG. 1, one electrode 2 and the other electrode 3 are disposed on front and back surfaces of a glass substrate 1, respectively. A state-changed, that is, crystallized portion 4 is formed in a glass substrate portion held between a pair of these electrodes. This state change is given by laser trimming means 10. A laser beam emitted from a laser light source 11 is passed through a splitter 12, mirror 13, and subsequently focused on the state-changed portion 4 by lenses 14 and 15. This focus is scanned by scanning means 16, and a laser beam 17 which gives the state change to a desired local portion can be formed.

The glass substrate 1 has a thickness of 0.1 to 0.5 mm, and dielectric constant before trimming can be selected from 4 to 10 by changing a material combination and composition.

One or two laser light sources with a high energy are used to focus on a desired portion inside the glass substrate by the lens and heat the portion for a short time, and a state of a glass forming material is changed from an amorphous state to a crystalline state. This state change is executed in a necessary region while a relative position of the laser trimmer (means) 10 and glass substrate 1 is changed by the scanning means 16.

In the circuit board of the first embodiment, only the region 4 between the electric-capacity electrodes 2 and 3 is subjected to the state change in the glass substrate 1, and the crystal grain or rod can locally be formed between the electrodes by the state change. FIG. 1 shows that a large number of crystal grains are formed. A diameter of the crystal grain or rod is in a range of 1 µm to several tens of micrometers, and permittivity of the crystal portion is about twice the permittivity of glass. Therefore, the capacity value can be changed by an occupancy ratio of a crystalline substance with respect to a glass substance. That is, the electric capacity value can be adjusted to be desirable by changing a density of crystal grains or rods. A generated amount of crystal material can be changed by laser intensity, irradiation time, and irradiated portion. Therefore, for the trimming, a trimmed amount is calculated from a desired capacity value and a capacity value before trimming, and a laser light amount, irradiation time (or pulse number), scanning amount, and crystallized amount are calculated. According to results, the laser light source 11 and scanning means 16 are controlled. A pulse laser having a high energy output such as excimer laser is used as the laser light source 11. Furthermore, in order to increase a heating selection property, a femto-second laser which can perform partial heating at a high speed is preferably used.

In an experiment, an output light of excimer laser was collected using the lens and focused in a predetermined position of the glass substrate so that a crystal having a diameter of several micrometers was generated. The condition is an energy density of 15 mJ per diameter of about 1 µm in the glass substrate. A processing condition changes with a glass material and laser beam property, but an energy of 10 mJ to 1000 mJ is injected. Additionally, an emission pulse width of the excimer laser was set to about 20 ns in the experiment. The pulse width of the excimer laser is in a range of 10 to 30 ns. The injected energy is 15 mJ, but one pulse has an extremely short time of 20 ns, and therefore 0.75 MW results from P = 15 mJ/20 ns. That is, the energy of 10 mJ/ns to 1000 mJ/ns is a powerful irradiation light corresponding to 0.5 MW to 100 MW.

Usually, trimming of an electric circuit constituting element means adjustment of property of a constituted circuit element. However, in the present invention, the adjustment of property can be performed both before and after constituting of the electric circuit constituting element. Therefore, either adjustment is generally referred to as trimming hereinafter unless otherwise specified.

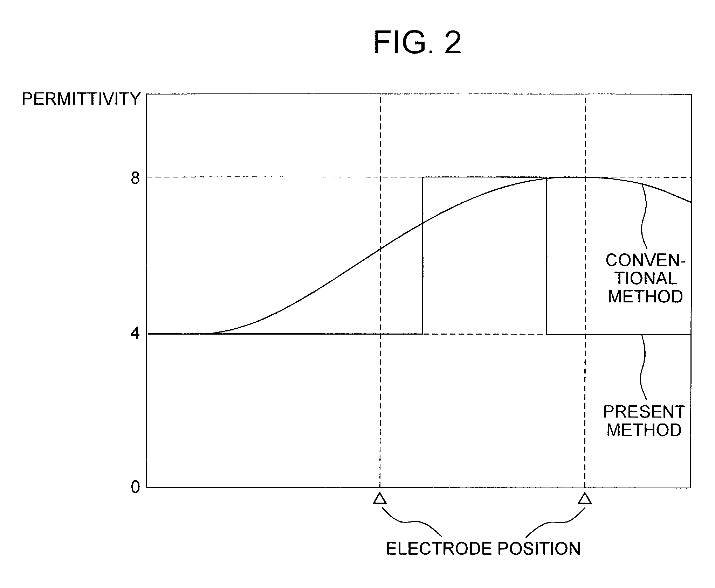

FIG. 2 is a graph showing permittivity profile after trimming in the first embodiment. A change of permittivity as a result of trimming is compared with that of a conventional method. As a first desired condition, the permittivity of only the position held between two electrodes is enhanced. However, in the conventional art, heat unnecessarily spreads as described above. As shown in FIG. 2, even an unnecessary portion is changed in property, and the property of another formed component possibly changes. On the other hand, in the method of the first embodiment, as a result of trimming, there is a clear boundary between a trimmed portion and a non-trimmed portion inside the glass substrate, and the permittivity of the trimmed portion is uniform. Therefore, according to the first embodiment, the capacity value can be trimmed without generating dirt during trimming or changing an outer configuration. Additionally, the element is irradiated with such high energy for a short time. The glass substance is changed to the crystal before the energy is dispersed as heat. Therefore, the portion to be trimmed and changed in property can be limited to a predetermined region during forming of the crystal grain. When the property of the crystal grain is uniformed and the number (density) of crystal grains is changed, trimming can be controlled in a digital manner, and trimming efficiency is effectively raised.

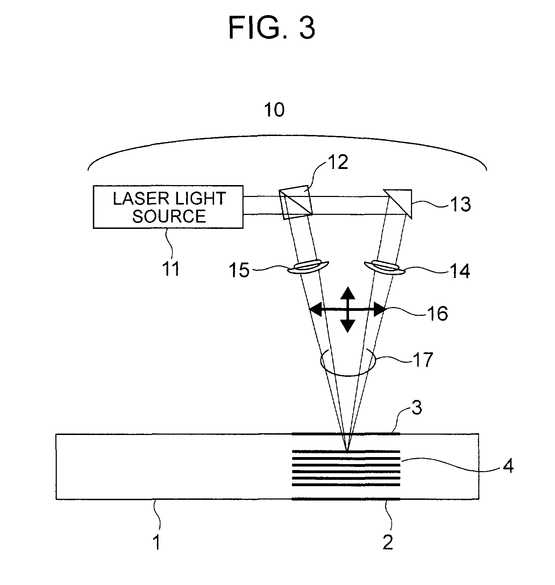

FIG. 3 shows a schematic sectional view of the circuit board and a schematic diagram of the trimming apparatus according to a second embodiment of the present invention. This is different from FIG. 1 in that the crystal rod is formed in the laser irradiated portion as a result of trimming. Even in this case, the trimming in which the periphery is not influenced and appearance is unchanged is possible without influencing the periphery. Moreover, the digital trimming control is effectively possible similarly as the first embodiment. Furthermore, it is also possible to form an optical waveguide in an interval of the crystal rods in a capacitor portion. In this case, the circuit board in which a high-frequency signal is handled can be formed without influencing a capacitor property. Therefore, mounting density of the whole electric circuit board can effectively be raised.

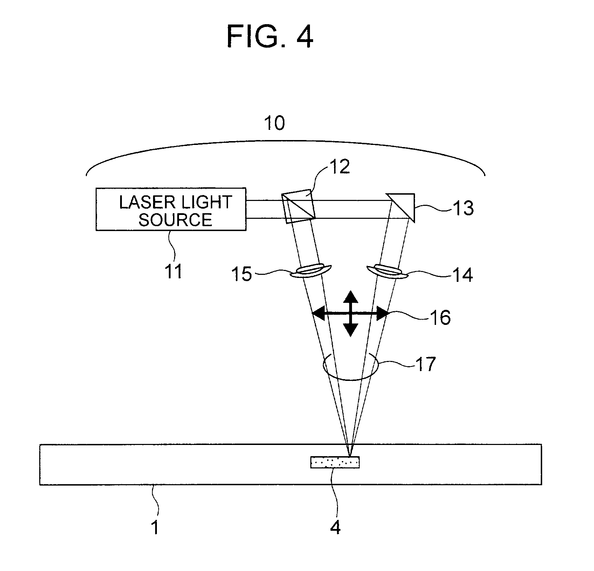

When only the desired portion inside glass is changed in state, disposing and trimming order of the electrode are important. This respect will be described hereinafter with reference to FIGS. 4 to 6.

FIG. 4 shows a schematic sectional view of the electric circuit board including the glass substrate of the first embodiment, in which the easily trimmable capacity of the present invention is disposed, and a schematic diagram of the trimming apparatus. In this embodiment, the surface of the glass substrate 1 is irradiated with the laser beam 17 substantially from a direction of a right angle, and trimmed before the electrode is formed in the glass substrate 1. Since the electrode is formed after trimming, the capacity different in value in a range of about twice the capacity can be formed without changing appearance. In the present embodiment, the material and size of the glass substrate 1, and trimming means (apparatus) 10 are not limited during laser irradiation, and the trimming apparatus 10 can easily and effectively be constructed.

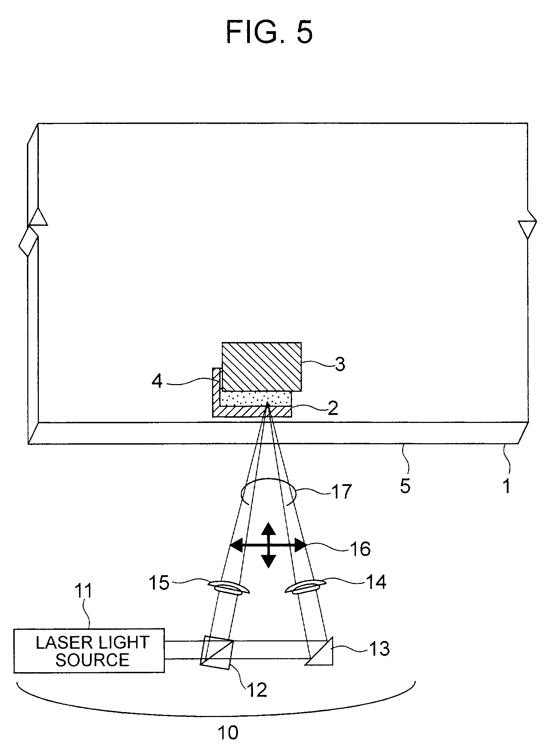

FIG. 5 shows a schematic perspective view of the electric circuit board including the glass substrate of the second embodiment, in which the easily trimmable capacity of the present invention is disposed, and a schematic diagram of the trimming apparatus. In this embodiment, a thickness of glass is set to such an extent that the glass substrate 1 can be irradiated with the laser beam via an end surface 5 of the substrate. Since the electrodes 2 and 3 are disposed as elements constituting the electric capacity on a glass surface in the vicinity of the end surface, the substrate can be trimmed after formation of the electrodes. Moreover, when the electrodes are formed before the trimming, a heat emission property is satisfactory. Furthermore, since the capacity value can be measured using the electrode, a measure unit is constituted integrally with the trimmer, and trimming can quickly be performed in association with a measured value.

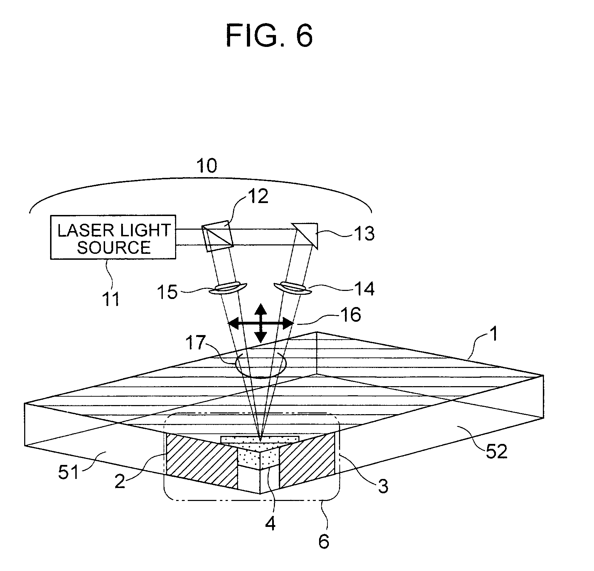

FIG. 6 shows a schematic perspective view of the electric circuit board including the glass substrate of a third embodiment, in which the easily trimmable capacity of the present invention is disposed, and a schematic diagram of the trimming apparatus. In FIG. 6, the electrodes 2 and 3 are disposed on end surfaces 51 and 52 of the glass substrate 1, respectively. As shown in FIG. 6, when the substrate is irradiated with the laser beam 17 substantially from the direction of the right angle with respect to the glass surface, a capacitor 6 can arbitrarily be trimmed without any influence onto the electrodes.

Three embodiments in which the capacity is disposed without any influence of laser beam irradiation onto the electrode have been described above. That is, as shown in (1) FIG. 4 the glass substrate 1 is trimmed via laser before the electrode is formed, and as shown in (2) FIG. 5 and (3) FIG. 6, the glass substrate is irradiated at an incident angle at which no laser beam is absorbed by the electrode. These methods may also be combined for use.

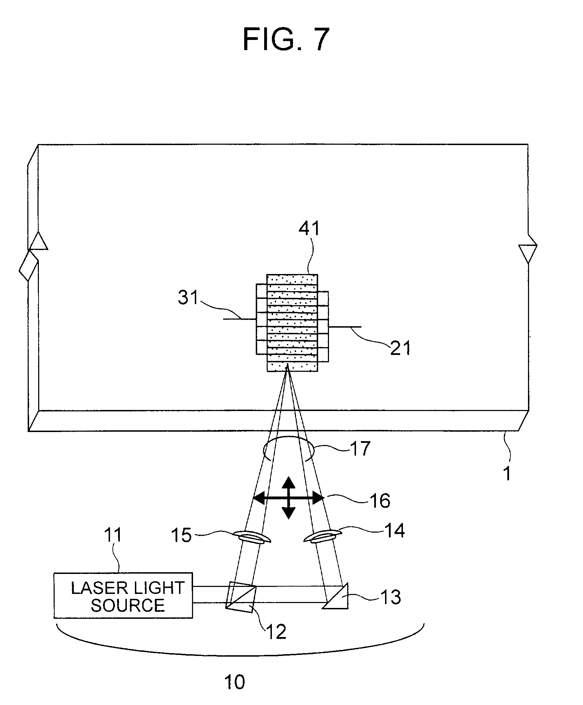

FIG. 7 shows a schematic sectional view of the electric circuit board including the glass substrate of a fourth embodiment, in which the easily trimmable capacity of the present invention is disposed, and a schematic diagram of the trimming apparatus. In FIG. 7, comb teeth shaped electrodes 21 and 31 are moved, butted and disposed on a plane of the glass substrate 1 and a dielectric 41 of a glass substance is laminated on the electrodes. Therefore, the dielectric 41 can be irradiated with the laser beam 17 having the direction of the right angle with respect to the plane of the glass substrate 1 from any direction of front and back surfaces of the substrate 1. If possible, in consideration of reliability the substrate is preferably trimmed from the back surface thereof. Additionally, in this structure, the electrode can also be trimmed, and the trimming condition of the electrode is different from that of the glass portion. However, the trimming of the electrode is the same as that of the glass portion in that the influence onto the other portions can be minimized by irradiation with a powerful electromagnetic wave for a short time.

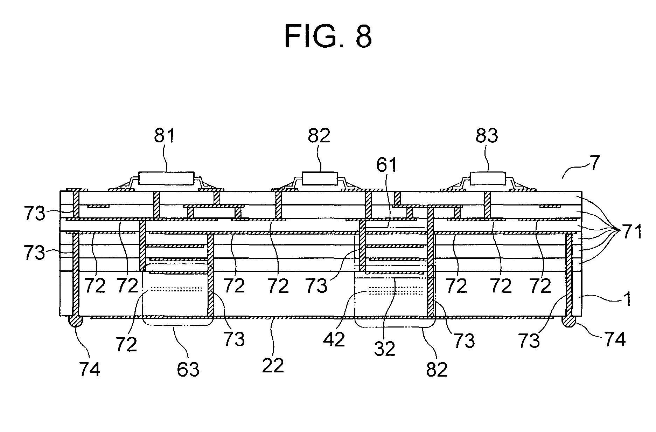

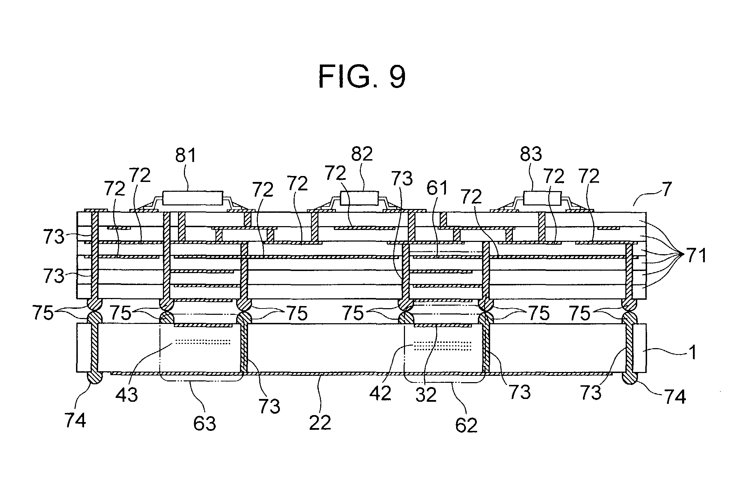

When the electric circuit board including the glass substrate according to the aforementioned embodiments is used, further various effects can be obtained. These effects will be described with reference to FIGS. 8 and 9.

FIG. 8 is a schematic sectional view of a first example of a multilayered electric circuit board according to the present invention. In FIG. 8, reference numeral 7 denotes a multilayered circuit board, 71 denotes an interlayer insulating layer, 72 denotes a wiring layer, 73 denotes a through hole, 22 denotes one electrode, 32 denotes the other electrode, 74 denotes a bump, and 42 and 43 denote crystallized portions. Numeral 61 denotes a capacity built in the substrate, 62 and 63 denote trimming capacities disposed in the glass substrate 1, and 81 to 83 denote discrete components. The wiring layer 72 is constituted of metals such as an aluminum (Al) alloy, copper (Cu), and tungsten (W). An upper-layer wiring is electrically connected to a lower-layer wiring via the through hole 73. Moreover, the wiring layer 72 is formed such that a linear width and wiring interval are narrowed toward the upper layer. For example, the linear width or the interval of a lowermost layer (first layer) is of the order of 10 to 30 µm, while that of an uppermost layer (fourth layer) is of the order of 1 to 10 µm. The interlayer insulating layer 71 is constituted of an oxide silicon film and an insulating material having a similar property, and a thickness thereof is about 10 µm. A soldering pad or a gold (Au) or tin (Sn) bump for mounting a plurality of external components 81 to 83 is formed in the uppermost-layer wiring, and is electrically connected to the wiring via the through hole 73 formed in the insulating layer. In a step of forming a circuit on the glass substrate 1 or mounting the external components, an alignment mark, formed beforehand on the glass substrate 1, for superposing a plurality of photo masks upon one another is used to advance semiconductor and module manufacturing processes. In these processes, the conventional art can be used. A size of the circuit board is variable with purposes in a range of 1 mm² to several tens of square millimeters. The circuit board is manufactured by forming a plurality of patterns and later dividing the patterns, and a usual semiconductor or substrate manufacturing process can be utilized. Additionally, the wiring 72 is disposed between the glass substrate 1 and the interlayer insulating layer 71, and needless to say, a treatment is performed to prevent glass reflection during the wiring step after formation of the interlayer insulating layer 71 from influencing a photolithography step. In such configuration, since the wiring 72 is used to form the electrode on the glass substrate 1, a capacity of about 0.2 pF can be formed, for example, with the material having a glass thickness of 0.4 mm, electrode area of 10 mm², and dielectric constant of 10. Moreover, when the crystal is formed in the glass substrate 1 by the laser beam irradiation, the dielectric constant of the irradiated portion is substantially doubled. Therefore, the capacity is formed by combining the capacity of a crystallized portion in series with the capacity of a non-crystallized portion, and a capacity value can be selected in a range of 0.2 pF to 0.4 pF in accordance with a ratio of the combined capacities. Additionally, besides crystallization by laser beam irradiation, it is also possible to deposit the crystal of a compound dispersed beforehand in glass. In this case, a broader range of capacity can supposedly be formed.

In this example, the capacity 62 is used as a trimming capacity with respect to the combined capacity of the capacity 61 formed in the multilayered circuit board 7 and the capacity 62 formed in the glass substrate 1. The trimming capacitor 62 is set to a small capacity value C2 with respect to a capacity C1 of the built-in capacitor 61, and the trimming capacity is adjusted in accordance with a permittivity change of glass before and after crystallization. In this case, C1 is connected in parallel to C2, and a combined capacity C0 is represented by the following equation: C0 = C1 + C2. Assuming that C2 is trimmed and set to C2 + Cx, the combined capacity is similarly C0 = C1 + C2 + Cx. Therefore, a relation of C is C1 > C2 > Cx. As compared with trimming of C1 itself, the capacity value can more precisely be adjusted without changing an outer configuration. Additionally, the trimming capacity 63 is another capacitor formed in the glass substrate 1, and can independently be trimmed.

FIG. 9 is a schematic sectional view of a second example of the multilayered electric circuit board according to the present invention. This example is different from FIG. 8 in that the glass circuit board 1 is bonded to the multilayered circuit board 7 via a small bump 75. When the boards are separately manufactured, respective suitable processes are used and manufacturing yield can be secured.

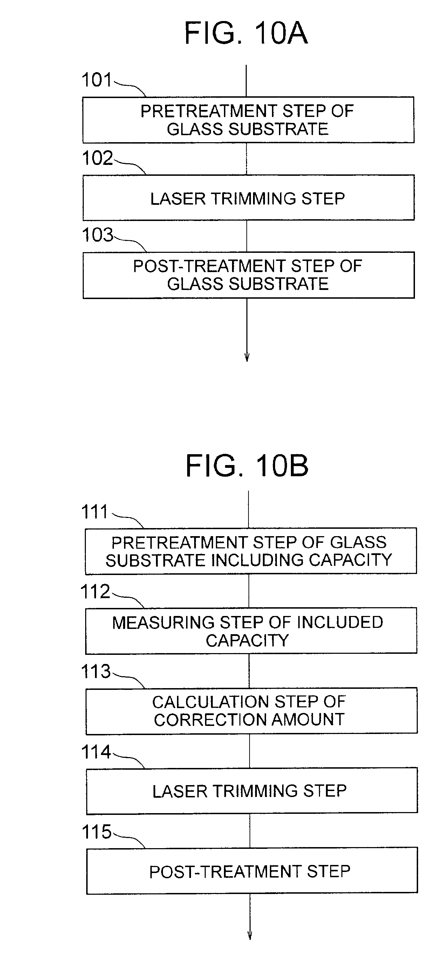

FIGS. 10A, 10B are flowcharts of a trimming adjustment process of the electric circuit board according to these examples. FIG. 10A shows that the glass substrate is trimmed before laminating the circuit, and FIG. 10B shows that the circuit board including an internal capacity is formed, the capacity value and circuit property are measured and subsequently the board is trimmed. In FIG. 10A, numeral 101 denotes a glass substrate pretreatment step of making a through hole in the glass substrate or cleaning the substrate before lamination, 102 denotes a laser trimming step of the predetermined portion of the trimming capacitor, and 103 denotes a post-treatment step of the glass substrate formed while the wiring and interlayer insulating layer are electrically connected via the through hole. In this case, the substrate is trimmed before forming the board. This can be applied when a trimming amount is known beforehand by a previous trial evaluation. Since the trimming step is performed before laminating the circuit, the step can effectively and freely be set.

In FIG. 10B, numeral 111 denotes a pretreatment step of the circuit board including the capacity, 112 denotes a measuring step of the included capacity value, 113 denotes a calculation step of a correction amount, 114 denotes a laser trimming step, and 115 denotes a post-treatment step. In this example, a post-treatment is performed which comprises measuring the capacity value of the capacitor formed in the interlayer insulating layer, calculating the correction amount of the trimming capacitor from the capacity value and a designed value, and controlling the laser light source 11 and operating means 16 in accordance with the calculated amount to correct the capacity value. There is an effect that a precise, reproducible and stable trimming can be performed in a short time.

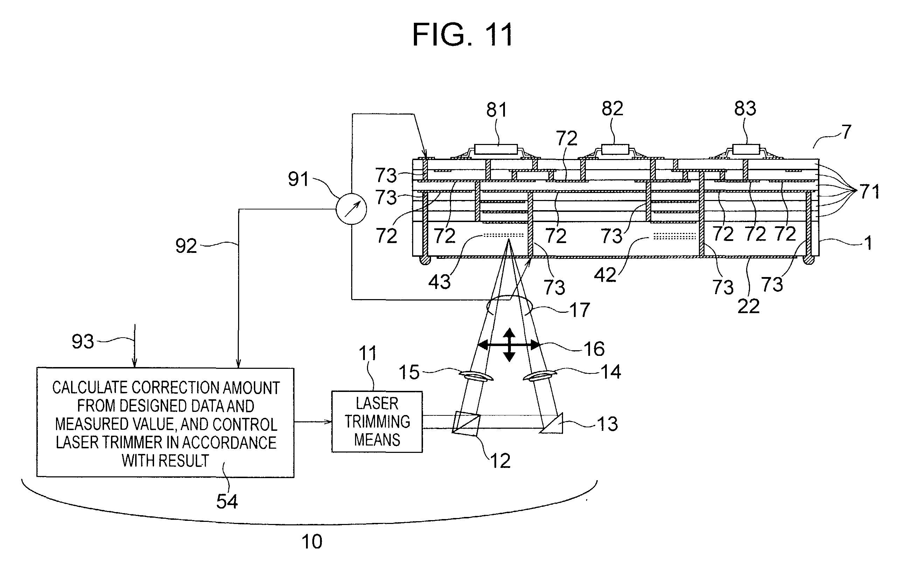

FIG. 11 is a schematic diagram of a manufacturing apparatus including an evaluation step and trimming step according to these embodiments of the present invention. Numeral 90 denotes a trimming apparatus combined with a board tester, 91 denotes property measuring means, 92 denotes measured data, 93 denotes designed data, and 94 denotes a laser trimmer controller. In the embodiment, the property evaluation step of the circuit board comprises measuring a circuit property, and using the result to process, crystallize and trim the trimming capacitor in an internal position of the glass substrate by a laser trimmer. In a subsequent step, the other electrode is formed. When the trimming apparatus of the embodiment is used, the capacitor is trimmed based on the property measured in the final step of the board. Therefore, precise trimming can effectively be performed in accordance with the properties of the individual completed circuit boards.

In the present embodiment, an example has been described in which crystallized glass is partially formed in the glass substrate and the capacity value is thereby changed. Even when an inductor or an integrated circuit is formed by the wiring, or even when the property is, for example, a filter property, this may be considered in calculating the correction amount of the circuit element from the measured value. Therefore, a case in which the dielectric constant of the circuit element is trimmed by partial crystallization inside the glass substrate by the laser beam falls into the scope of the present embodiment.

Moreover, in a manufacturing apparatus of the circuit board, in which the measuring means of the circuit property, laser trimming means and means for controlling the trimming are integrally constituted, a common portion of the apparatus can effectively be shared. Additionally, a manufacturing time can be shortened and throughput can be improved.

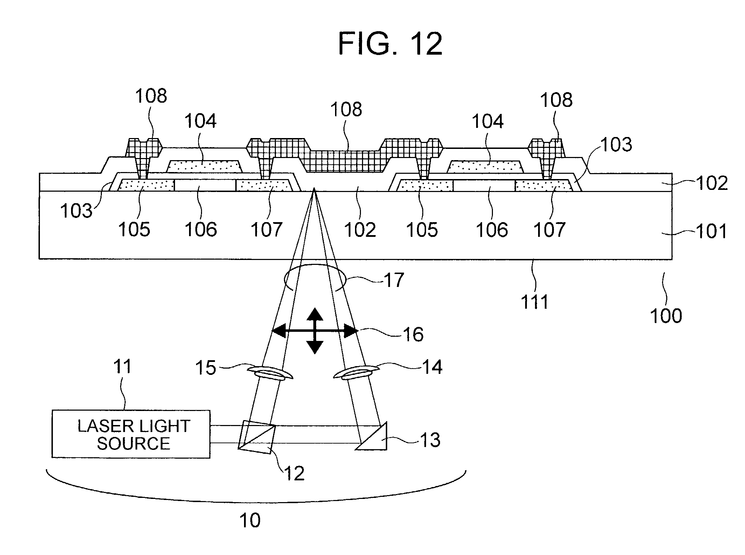

Additionally, the present invention is not limited to a multi chip module (MCM), but can be modified/applied, and can also be applied, for example, to a liquid crystal panel. This will be described with reference to FIG. 12.

FIG. 12 is a schematic sectional view of the glass substrate on a circuit side of the liquid crystal panel during modifying of the wiring. Numeral 100 denotes a liquid crystal panel, 101 denotes a glass substrate, 102 denotes an interlayer insulating film, 103 denotes a gate oxide film, 104 denotes a gate, 105 denotes a source, 106 denotes a channel, 107 denotes a drain, 108 denotes a metal wiring, and 111 denotes a back surface of the glass substrate. In a latest TFT liquid crystal panel, a circuit constituted of a display image signal driving source including a switch matrix, scanning circuit, and DA conversion circuit is formed on the glass substrate by Poly-Si, resistor, capacitor, electrode, wiring, and the like. When the trimming of the present invention is applied to the adjustment and correction of the circuit of the liquid crystal panel, the wiring is formed and further the property of the electric circuit constituting element can be adjusted, for example, in the circuit constituted of Si, resistor, wiring, and the like disposed on the front surface from the back surface of the transparent glass substrate without contacting the appearance. A typical example includes a resistor R, and a reactance L. Since the resistor R is constituted in a film shape, the width of the resistor is trimmed to change a section thereof. The reactance L is formed in a coil shape for taking a magnetic flux or a strip line shape, and trimmed by changing a length of the reactance. The trimming condition largely differs with each laser light absorption ability. Additionally, needless to say, the electrode shape can be changed similarly as the prior art to trim the capacity C.

Moreover, even when the glass substrate is trimmed from the front surface thereof, the substrate can be trimmed in a short time without conducting heat to the periphery. In the trimming, deterioration can be minimized.

According to the aforementioned embodiments, the electric circuit constituting element of the electric circuit board including the glass substrate can locally be trimmed in an aiming manner by short-time irradiation of the powerful electromagnetic wave such as the laser beam, and there is little possibility that the peripheral components are aversely affected. Moreover, when the state is changed in the glass substrate, the electric capacity value can be trimmed without changing the outer configuration. Furthermore, when the crystal is formed in the crystal grain and/or the crystal rod, the trimming can be performed with satisfactory controllability. Besides the capacity, the electric circuit elements such as the resistor, reactance, wiring and electrode can also be trimmed.

Moreover, when the trimming capacitor for adjusting the capacity value of the capacitor is formed in the glass substrate portion separately from the capacitor formed in the interlayer insulating material, the electric capacity value can more precisely be adjusted without changing the outer configuration.

When a transparent conductive film such as indium tin oxide (ITO) is used in the electrode, needless to say, the capacity can be trimmed through the electrode in a laser irradiation structure not-focusing on the conductive film.

The following are disclosed in the present specification.
(1) A trimming method of an electric circuit board including a glass substrate, and an electric circuit constituting element on or inside the glass substrate, the method comprising: a step of focusing an electromagnetic wave onto the predetermined electric circuit constituting element inside or on the glass substrate through the glass substrate; and a step of adjusting an electric property of the predetermined electric circuit constituting element positioned in the vicinity of a focus of the electromagnetic wave.
(2) A trimming method of an electric circuit board including a glass substrate, an electric circuit constituting element inside the glass substrate, and a pair of electrodes disposed so as to hold the electric circuit constituting element therebetween, the method comprising: a step of focusing a laser beam emitted from a laser light source onto the predetermined electric circuit constituting element inside the glass substrate through the glass substrate in such a manner that the electrodes are avoided; and a step of adjusting an electric property of the predetermined electric circuit constituting element by irradiation with the laser beam for a short time.
(3) A trimming method of an electric circuit board including a glass substrate, and an electric circuit constituting element inside the glass substrate, the method comprising: a step of focusing a laser beam emitted from a laser light source onto a dielectric disposed or to be disposed in the glass substrate through the glass substrate; and a step of changing a state of the dielectric by irradiation with the laser beam for a short time and adjusting an electric property of the predetermined electric circuit constituting element.
(4) The trimming method of the electric circuit board including the glass substrate according to any one of (1) to (3), further comprising a step of forming a crystal grain and/or a crystal rod in the glass substrate by irradiation with the electromagnetic wave or the laser beam.
(5) The trimming method of the electric circuit board including the glass substrate according to any one of (1) to (4), further comprising a step of partially changing a state of a dielectric disposed and/or to be disposed in the glass substrate and adjusting an electric capacity.
(6) The trimming method of the electric circuit board including the glass substrate according to any one of (1) to (3), further comprising a step of partially cutting a wiring disposed in the glass substrate and adjusting the electric property.
(7) The trimming method of the electric circuit board including the glass substrate according to any one of (1) to (5), further comprising a step of partially removing or cutting an electrode of an electric capacity disposed in the glass substrate and adjusting the electric property.
(8) An electric circuit board including a glass substrate, comprising: the glass substrate; a wiring formed on a main surface and/or a back surface of the glass substrate; a plurality of external connection terminals electrically connected to the wiring; and an external electric component connected to the external connection terminals, wherein a state change portion is partially disposed inside the glass substrate.
(9) An electric circuit board including a glass substrate, comprising: the glass substrate; a wiring formed on a main surface and/or a back surface of the glass substrate; a through hole and/or an end-surface wiring for electrically connecting the wiring formed on the main surface of the glass substrate to the main surface and the back surface of the glass substrate; a plurality of external connection terminals formed on the back surface of the glass substrate and electrically connected to the wiring disposed on the main surface; and an external component connected to some of the external connection terminals, wherein a state of the glass substrate is partially changed by irradiation of an electromagnetic wave focusing on the inside of the glass substrate.
(10) The electric circuit board including the glass substrate according to (8) or (9), further comprising: a superposed multilayered substrate; an electric capacity disposed on the multilayered substrate; and an electric capacity disposed by a state change in the glass substrate.
(11) The electric circuit board including the glass substrate according to (10), wherein the electric capacity in the glass substrate is trimmed by irradiation with an electromagnetic wave and a combined electric capacity value is adjusted.
(12) The electric circuit board including the glass substrate according to (8) or (9) wherein the electric circuit board is a liquid crystal panel in which a large number of electric circuit constituting elements are formed.
(13) The electric circuit board including the glass substrate according to any one of (8) to (12), further comprising an electrode of an electric capacity formed on the glass substrate after the electric capacity is trimmed by the state change in the glass substrate.
(14) A trimming method of an electric circuit board including a glass substrate, comprising: a process of forming an electric circuit on a glass substrate; a process of forming a trimmable passive component; a process of forming another passive component; a process of mounting another component; a process of measuring an electric property of a mounted circuit board; a process of calculating a trimming amount from a measured value; and a process of focusing on and irradiating the inside of the glass substrate with an electromagnetic wave based on the calculated trimming amount and subjecting a part of the inside of the glass substrate to state change.
(15) A trimming apparatus of an electric circuit board including a glass substrate, comprising: means for measuring an electric property of a mounted circuit board; means for calculating a trimming amount from a measured value; focusing on and irradiating the inside of the glass substrate with an electromagnetic wave based on the calculated trimming amount and partially trimming the inside of the glass substrate; and means for managing information of the measured value and the trimming amount.

## Claims

1. A trimming method of an electric circuit board including a glass substrate (1), and an electric circuit constituting element on or inside the glass substrate (1), said method comprising steps of
focusing an electromagnetic wave (17) onto said predetermined electric circuit constituting element inside or on said glass substrate (1) through said glass substrate (1); and
adjusting an electric property of said predetermined electric circuit constituting element positioned in the vicinity of a focus of said electromagnetic wave.

2. A trimming method of an electric circuit board including a glass substrate (1), an electric circuit constituting element inside the glass substrate (1), and a pair of electrodes (2, 3) disposed so as to hold the electric circuit constituting element therebetween, said method comprising steps of
focusing a laser beam (17) emitted from a laser light source (11) onto said predetermined electric circuit constituting element inside said glass substrate (1) through said glass substrate (1) in such a manner that said electrodes are avoided; and
adjusting an electric property of said predetermined electric circuit constituting element by irradiation with the laser beam (17) for a short time.

3. A trimming method of an electric circuit board including a glass substrate (1), and an electric circuit constituting element inside the glass substrate (1), said method comprising steps of
focusing a laser beam (17) emitted from a laser light source (11) onto a dielectric disposed or to be disposed in said glass substrate (1) through said glass substrate (1);
changing a state of said dielectric by irradiation with the laser beam (17) for a short time and
adjusting an electric property of the predetermined electric circuit constituting element.

4. The trimming method of the electric circuit board including the glass substrate (1) according to claim 1, comprising a step of forming a crystal grain and/or a crystal rod in said glass substrate (1) by irradiation with said electromagnetic wave or the laser beam (17).

5. The trimming method of the electric circuit board including the glass substrate according to claim 1, comprising a step of partially changing a state of a dielectric disposed and/or to be disposed in said glass substrate and adjusting an electric capacity.

6. The trimming method of the electric circuit board including the glass substrate according to claim 1, comprising a step of partially cutting a wiring disposed in said glass substrate and adjusting the electric property.

7. The trimming method of the electric circuit board including the glass substrate according to claim 1, comprising a step of partially removing or cutting an electrode of an electric capacity disposed in said glass substrate and adjusting the electric property.

8. An electric circuit board including a glass substrate, comprising:
the glass substrate (1);
a wiring formed on a main surface and/or a back surface of the glass substrate (1); a plurality of external connection terminals electrically connected to the wiring;
and an external electric component connected to the external connection terminals,
wherein a state change portion is partially disposed inside said glass substrate.

9. An electric circuit board including a glass substrate, comprising:
the glass substrate (1);
a wiring formed on a main surface and/or a back surface of said glass substrate (1); a through hole and/or an end-surface wiring for electrically connecting the wiring formed on the main surface of said glass substrate (1) to the main surface and the back surface of the glass substrate (1);
a plurality of external connection terminals formed on the back surface of said glass substrate (1) and electrically connected to the wiring disposed on said main surface; and
an external component connected to some of said external connection terminals,
wherein a state of said glass substrate (1) is partially changed by irradiation of an electromagnetic wave (17) focusing on the inside of the glass substrate (1).

10. The electric circuit board including the glass substrate (1) according to claim 8, comprising: a superposed multilayered substrate; an electric capacity disposed on the multilayered substrate; and an electric capacity disposed by a state change in said glass substrate (1).

11. The electric circuit board including the glass substrate according to claim 10, wherein the electric capacity in said glass substrate is trimmed by irradiation with an electromagnetic wave and a combined electric capacity value is adjusted.

12. The electric circuit board including the glass substrate according to claim 8, wherein said electric circuit board is a liquid crystal panel in which a large number of electric circuit constituting elements are formed.

13. The electric circuit board including the glass substrate according to claim 8, comprising an electrode of an electric capacity formed on said glass substrate after the electric capacity is trimmed by a state change in said glass substrate.

14. A trimming method of an electric circuit board including a glass substrate, comprising:
a process of forming an electric circuit on a glass substrate (1);
a process of forming a trimmable passive component;
a process of forming another passive component;
a process of mounting another component;
a process of measuring an electric property of a mounted circuit board;
a process of calculating a trimming amount from a measured value; and
a process of focusing on and irradiating the inside of the glass substrate with an electromagnetic wave (17) based on the calculated trimming amount and subjecting a part of the inside of the glass substrate to state change.

15. A trimming apparatus of an electric circuit board including a glass substrate, comprising:
means for measuring an electric property of a mounted circuit board;
means for calculating a trimming amount from a measured value;
means for focusing on and irradiating the inside of the glass substrate with an electromagnetic wave (17) based on the calculated trimming amount and partially trimming the inside of the glass substrate (1); and
means for managing information of said measured value and said trimming amount.
